# EUROPEAN PATENT APPLICATION

(11) **EP 2 408 019 A2**
(43) Date of publication of application: **18.01.2012**
(21) Application number: 11171160.2
(22) Date of filing: 23.06.2011
(51) Int. Cl.: H01L 31/05, H01L 31/18

(54) **Photovoltaic (pv) module with improved bus tape to foil ribbon contact**

(30) Priority: 29.06.2010 US 825495
(71) Applicant: PrimeStar Solar, Inc, Arvada, CO 80004 (US)
(72) Inventor: Kabade, Rajendra Rambhau, Arvada, CO Colorado 80004 (US)
(74) Representative: Bedford, Grant Richard

(57) **Abstract**

A photovoltaic (PV) module (10), and associated method of making, includes a substrate (12) having a plurality of individual serially connected solar cells (16) defined thereon. A bus tape (28) is applied to the substrate generally at each opposite longitudinal end (18) thereof. The bus tapes are applied over the extreme opposite solar cells for collecting the charge generated by the plurality of solar cells. A foil ribbon (22) is connected between the bus tapes and to an intermediate junction box (24) that is configured for delivering the generated charge to an external load or other component. At a point of electrical connection between the bus tapes and the foil ribbon, the bus tapes are disposed beneath the foil ribbon and a conductive solder (30) is between the foil ribbon and bus tapes.

## Description

The subject matter disclosed herein relates generally to photovoltaic (PV) modules, and more particularly to an improved contact between bus tapes and foil ribbon on PV modules.

Thin film photovoltaic (PV) modules (also referred to as "solar panels") are gaining wide acceptance and interest in the industry. The PV modules are conventionally formed by deposition of various semiconductor materials and electrode layers as thin (generally recognized in the art as less than 10 microns) film layers on a glass substrate. The substrate then undergoes various processing steps, including laser scribing processes, to define and isolate individual cells, define a perimeter edge zone around the cells, and to connect the cells in series. These steps result in generation of a plurality of individual solar cells defined within the physical edges of the substrate.

A well known method for collecting the charge from a PV module is to attach a strip of insulation (e.g., an insulating tape) lengthwise along the module across the cells. A conductive foil (e.g. a foil tape or ribbon) is then aligned and attached to the insulation tape. Bus bars (typically in the form of an adhesive bus tape) are then attached at opposite longitudinal ends of the module aligned with the first and last cells, respectively. The bus tapes cross over and attach to the foil layer, collect the charge from the cells, and transfer the charge to the foil ribbon. The foil ribbon is separated in a junction box wherein leads are connected to the separated foil ends. The leads provide a means to connect the PV module to a load, other cells, a grid, and so forth.

The electrical junction between the bus tapes and foil ribbon is critical to the PV module. If the junction fails at either location, an open circuit is created and the PV module becomes useless. Unfortunately, this junction has proven to be problematic. The bus tapes are typically embossed and include a non-conductive adhesive applied to the tape. Electrical contact between the bus tapes and foil ribbon is thus dependent on sufficient ridge depth created by the embossment process. The adhesive is intended to secure the tape to the foil ribbon, but the ridges must penetrate through the adhesive to make electrical contact with the foil ribbon. If the ridge depth is insufficient or the ridges become crushed in the application process, electrical contact is not made or is unreliable. In addition, failure of the adhesive results in the tape pulling away from the foil ribbon, again resulting in loss of electrical contact. This is a particular concern with repeated temperature cycling of the module.

Accordingly, there exists an ongoing need in the industry for an improved, robust, and more reliable electrical contact between the bus tapes and foil ribbon that will reduce the occurrence of failed PV modules.

Various aspects and advantages of the invention will be set forth in part in the following description, or may be clear from the description, or may be learned through practice of the invention.

In accordance with a particular embodiment, a photovoltaic (PV) module is provided having a plurality of individual and serially connected solar cells defined thereon. A bus tape is applied to the substrate generally at each opposite longitudinal end thereof. The bus tapes are in electrical contact with the respective extreme opposite solar cells and serve to collect the charge generated by the plurality of solar cells. A conductive member, such as a foil ribbon, tape, strip, or the like, interconnects the bus tapes and is, in turn, connected to a junction box that is configured with leads for delivering the generated charge to an external load, connecting the PV module to other modules or a grid, and so forth. At the point of electrical connection between the bus tapes and the foil ribbon, the bus tapes are disposed beneath the foil ribbon and a conductive adhesive material, such as a solder, epoxy, adhesive, or the like, attaches the conductive member to the bus tapes and ensures a strong, low resistance electrical contact between the components.

In certain embodiments, the conductive material is a foil ribbon that overlies an insulating material (e.g., a strip, tape, or the like) and the bus tapes cross over the insulating material strip. The bus tapes may include an adhesive layer for attaching to the substrate and to the insulating material strip.

The conductive adhesive material may be a low temperature solder having a melting point of between about 100 degrees Celsius to about 150 degrees Celsius. In a particular embodiment, the solder is Sn-Bi alloy having a melting point of about 138 degrees Celsius.

Variations and modifications to the embodiment of the photovoltaic module discussed above are within the scope and spirit of the invention and may be further described herein.

The present invention also encompasses method embodiments for attaching bus tapes and a conductive ribbon to photovoltaic (PV) module substrates. A particular method embodiment includes applying a strip of insulation material (e.g., an insulation tape) along the length of the substrate traversing the individual solar cells. Bus tapes are applied at opposite longitudinal ends of the substrate aligned with the first and last cells, with each of the bus tapes crossing over the insulation tape. An adhesive conductive material, such as a low temperature solder, is dispensed onto the top surface of the bus tapes at the crossover location with the insulation tape. A conductive ribbon, such as a foil ribbon, is then applied so as to overlie the insulation tape and extend over the bus tape and adhesive conductive material at the crossover locations. In the embodiment wherein the adhesive conductive material is a solder, the substrate is then heated at least at the crossover locations to reflow the solder such that the conductive ribbon bonds to and makes an electrical connection with the bus tapes. The heating process may be done with a localized heat source applied to the crossover locations or, in an alternate embodiment, may be accomplished in a subsequent lamination process that generates sufficient heat to reflow the solder.

Variations and modifications to the embodiment of the method discussed above are within the scope and spirit of the invention and may be further described herein.

Various features, aspects and advantages of the present invention will become better understood with reference to the following description, appended claims, and drawings, in which:
Fig. 1 is a view of a back side of a photovoltaic module (PV);
Fig. 2 is a view of the front side of the PV module of Fig. 1;
Fig. 3 is a back view of a PV module particularly illustrating the foil ribbon and bus tapes;
Fig. 4 is an enlarged diagrammatic view of the connection location of the foil ribbon and bus tapes in accordance with aspects of the invention; and,
Fig. 5 is side cut-away view of the connection between the foil ribbon and bus tape.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment, can be used with another embodiment to yield a still further embodiment. Thus, it is intended that the present invention encompass such modifications and variations as come within the scope of the appended claims and their equivalents.

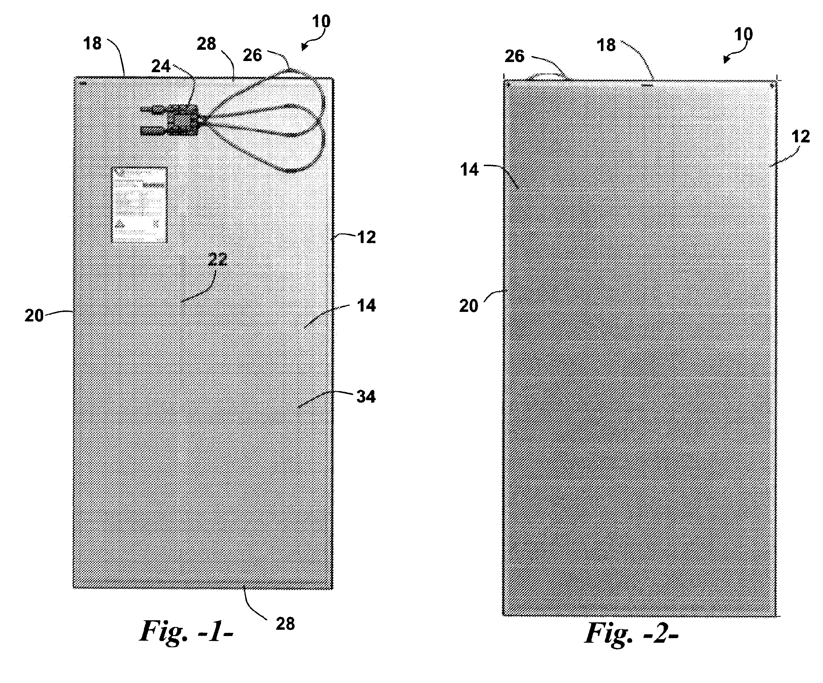

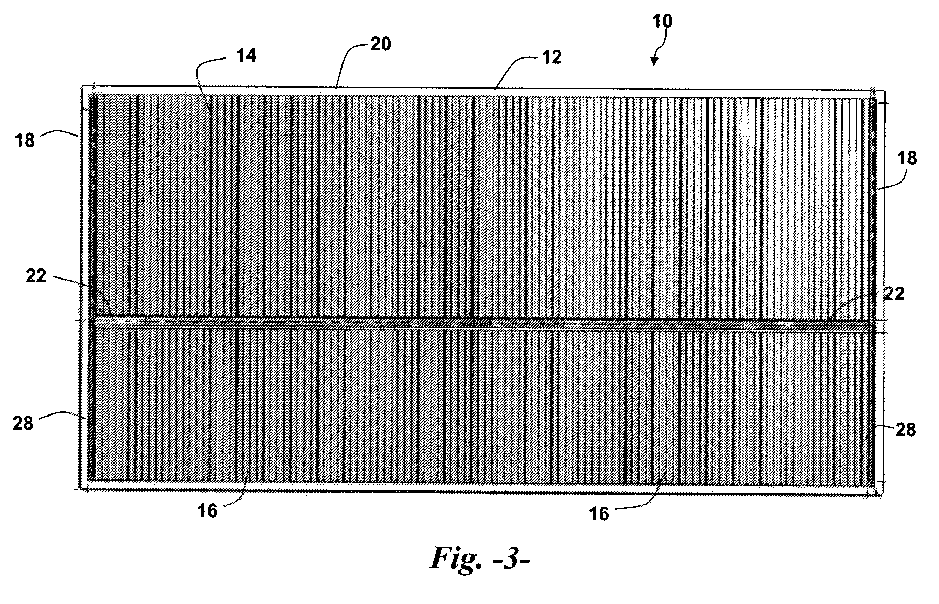

Figs. 1 and 2 illustrate a photovoltaic (PV) module 10. Fig. 1 is a view of the back side of the module and Fig. 2 is a view of the front side of the module 10 that is exposed to sunlight for generation of electricity. The module 10 includes a substrate 12 (typically a glass substrate) with opposite longitudinal ends 18 and sides 20. Referring to Fig. 1, a junction box 24 is provided with leads 26 that allow the module 10 to be connected to a load, other modules, an electrical grid, and so forth. As is well known in the art, the module 10 includes a plurality of individual solar cells 16 (Fig. 3) that are defined by scribe lines 14 formed in the various thin film semiconductor layers deposited onto the substrate 12. The individual solar cells 16 are connected in series, and the charge generated by the cells is collected via bus tapes 28, a foil ribbon 22, and a junction box 24 with associated leads 26, as discussed in greater detail below.

Fig. 1 illustrates the back side of the PV module 10 in a completed state wherein a laminate sheet 34 has been applied over the cells 16, foil ribbon 22, and bus tapes 28. Fig. 3 illustrates the back side of the module 10 prior to application of the laminate 34 and junction box 24. Referring to Fig. 3, an electrically conductive bus tape 28 is aligned with the first and last solar cells at each of the opposite longitudinal ends of the substrate 12. The respective bus tapes 28 are centered over the first cell at one end of the module 10 and over the extreme opposite last cell at the opposite longitudinal end of the PV module 10. Thus, the bus tape 28 over the first cell constitutes the positive (+) side of the module 10 and the opposite bus tape 28 constitutes the negative (-) side of the module 10.

The bus tape 28 is an electrically conductive material that serves to collect the charge across the length of the cell over which it is centered. In this regard, the tape 28 must be securely adhered over the cell and make sufficient electrical contact with the cell. A number of conventional and commercially available bus tapes are available for this purpose. For example, 3M Corporation supplies an embossed bus tape having a pre-applied adhesive thereon. The adhesive is non-conductive and serves to attach the bus tape 28 to the substrate. The embossed pattern creates ridges that essentially extend through the adhesive and make point and line contact with the solar cell 16.

A conductive member interconnects the bus tapes 28. In a particular embodiment, this conductive member is a foil tape, strip, or ribbon 22 that is connected to the respective bus tapes 28 and extends the longitudinal length of the PV module 10. As is a common practice in the art, the conductive member 22 is centered on an insulation material deposited over the cells so that the foil ribbon does not short any of the cells. The insulation material is typically an adhesive insulation tape 32.

As is understood in the art, the conductive member 22 is eventually separated at a location where the junction box 24 is installed, with each of the leads 26 attached to one of the separated ends of the conductive member 22. This construction is well known to those in the art and need not be described in detail for an appreciation of the present invention.

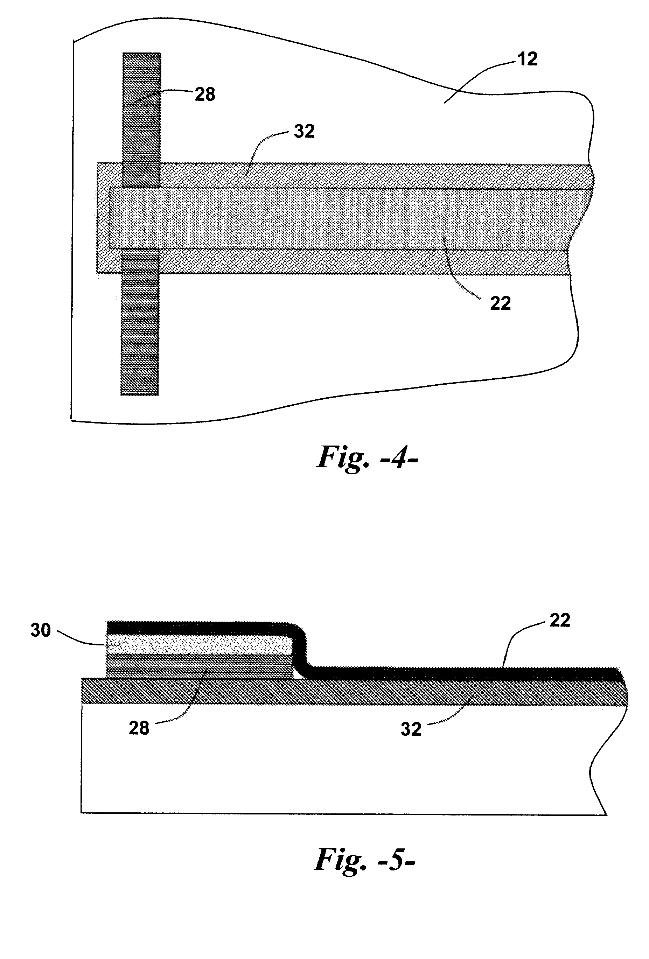

Referring to Figs. 4 and 5 in particular, at the point of electrical contact between the conductive member 22 and bus tapes 28 at the opposite longitudinal ends 18 of the PV modules 10, the bus tapes 28 are disposed under the conductive member 22. For example, referring still to Figs. 4 and 5, the insulation tape 32 may be the first component that is applied along the longitudinal length of the PV module 10 from the first solar cell 16 to the last solar cell at the opposite end of the module 10. The bus tapes 28 may then be applied across the insulation tape 32 so as to be aligned over the respective first and last cells 16. It should be appreciated that, in an alternative embodiment, the bus tapes 28 needs not cross over the insulation tape 32. In other words, the insulation tape 32 may extend between the bus tapes 28.

A layer of a conductive adhesive material 30 is applied on top of the bus tapes 28 at the cross-over location with the insulation tape 32 where the conductive member 22 will connect to the bus tapes 28. This material 30 may be, for example, a low resistance homogeneously conductive epoxy, glue, solder, or any other suitable type of conductive compound or material that serves to adhere the conductive member 22 to the bus tapes 28 with the desired electrical contact characteristics. In a particular embodiment, the material 30 is solder, preferably a low temperature solder having a melting point of between about 100° C to about 150° C. In a particular embodiment, the solder is a Sn-Bi alloy having a melting point of about 138° C. Numerous conductive low temperature solders are available and may be used for this purpose. The conductive material 22 is then applied and extends over the conductive adhesive material 30, as particularly depicted in Fig. 5.

In the embodiment wherein the material 30 is a solder, in a subsequent processing step, the solder material 30 is heated and reflows, which results in the conductive material strip 22 being bonded to the underlying bus tape 28. The conductive solder ensures a strong and robust electrical securement between the conductive material strip 22 and the bus tape 28 while providing a relatively low resistance electrical contact between the components.

The solder may be applied between the foil ribbon 22 and bus tapes 28 in any suitable amount and pattern. For example, the solder may be applied in a uniform coating having a thickness that is generally about the same thickness as the bus tape 28.

The solder may be heated and reflow in a subsequent processing step wherein a localized heat source is applied to the cross-over location between the bus tapes 28 and conductive member 22. For example, a heat rod, roller, or the like, may be applied at the cross-over location. In an alternative embodiment, the subsequent lamination step wherein the lamination sheet 34 is applied to the back side of the module 10 may provide sufficient heat for causing the solder 30 to reflow. In this embodiment, a separate heating step would not be necessary.

It should be readily appreciated that the present invention also encompasses any methodology embodiment for forming the improved connection between the bus tapes 28 and conductive member 22, as discussed above. For example, the present invention includes a method embodiment wherein a strip of insulation material, such as the insulation tape 32, is applied along the length of the PV substrate 12 over the individual solar cells 16. The insulation material may extend from one extreme end 18 to the other end of the module 10. Bus tapes 28 are applied at the opposite longitudinal ends of the substrate 12 so as to overlie the respective first and last solar cells 16. Each of the bus tapes 28 crosses over the insulation tape 32 if the tape extends over the respective first and last cells. The method further includes dispensing a conductive adhesive material 30, such as a low melt temperature solder, onto the top of the bus tapes 28 at the cross-over location with the insulation tape 32 (the location for subsequent bonding of the conductive member 22). A conductive member 22, such as a foil ribbon, is then applied to the substrate so as to overlie the insulation tape 32 and to extend over the bus tape 28 and material 30 at the cross-over locations.

In the embodiment wherein the conductive adhesive material 30 is a solder, the substrate 12 is heated at least at the cross-over locations to reflow the solder 30 such that the conductive member 22 bonds to and makes an electrical connection with the bus tapes 28. The heating process may be done with a localized heat source applied to the cross-over locations or, in an alternative embodiment, may be accomplished in a subsequent lamination process that generates sufficient heat to reflow the solder.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A photovoltaic (PV) module, comprising:
   a substrate having a plurality of individual serially connected solar cells defined thereon;
   a bus tape applied to said substrate at a location for collecting the charge generated by said plurality of solar cells;
   a conductive member interconnected between said bus tapes;
   a junction box configured for delivering the generated charge to an external load or other component, said conductive member connected to said junction box;
   a point of electrical connection between said bus tapes and said conductive member, said bus tapes disposed beneath said conductive member at said point of electrical connection; and,
   a layer of conductive adhesive material between said conductive material and said bus tapes.
2. The photovoltaic (PV) module as in clause 1, wherein said conductive member is a foil ribbon, and further comprising an insulating material strip beneath said foil ribbon, said bus tapes disposed on top of said insulating material strip.
3. The photovoltaic (PV) module as in any preceding clause, wherein said bus tapes include an adhesive layer for attaching to said substrate and to said insulating material strip.
4. The photovoltaic (PV) module as in any preceding clause, wherein said conductive adhesive material comprises a solder.
5. The photovoltaic (PV) module as in any preceding clause, wherein said solder comprises a low temperature solder having a melting point of between about 100 degrees Celsius to about 150 degrees Celsius.
6. The photovoltaic (PV) module as in any preceding clause, wherein said layer of conductive adhesive material comprises a solder having a thickness about the same as said bus tape.
7. A method for attaching bus tapes and a ribbon of conductive material to photovoltaic (PV) module substrates, said method comprising:
   applying a strip of insulation tape along the length of the substrate;
   applying bus tapes at opposite longitudinal ends of the substrate, each of the bus tapes crossing over the insulation tape;
   dispensing a layer of conductive adhesive material onto the top surface of said bus tapes at the crossover location with the insulation tape; and,
   applying a conductive member so as to overly the insulation tape and extend over the bus tape and conductive adhesive material at the crossover location.
8. The method as in any preceding clause, wherein the conductive adhesive material is a solder, said method further comprising heating the substrate at least at the crossover locations to reflow the solder such that the conductive member bonds to and makes an electrical connection with the bus tapes.
9. The method as in any preceding clause, wherein said solder has a melting point of between about 100 degrees Celsius to about 150 degrees Celsius.
10. The method as in any preceding clause, wherein the solder is heated and reflows in a subsequent lamination step wherein a laminate layer is adhered to the substrate.
11. The method as in any preceding clause, wherein the solder is heated and reflows by application of a localized heat source to the crossover locations.
12. The method as in any preceding clause, wherein the bus tapes are adhered with an adhesive to the substrate and to the insulation tape at the crossover locations.

## Claims

1. A photovoltaic (PV) module (10), comprising:
a substrate (12) having a plurality of individual serially connected solar cells (16) defined thereon;
a bus tape (28) applied to said substrate generally at each opposite longitudinal end (18) thereof, said bus tapes applied along extreme opposite solar cells for collecting the charge generated by said plurality of solar cells;
a foil ribbon (22) interconnected between said bus tapes, said foil ribbon connected to a junction box (24) that is configured for delivering the generated charge to an external load or other component;
at a point of electrical connection between said bus tapes and said foil ribbon, said bus tapes disposed beneath said foil ribbon; and
a conductive solder (30) between said foil ribbon and said bus tapes.

2. The photovoltaic (PV) module (10) as in claim 1, further comprising an insulating material strip (32) beneath said foil ribbon (22), said bus tapes (28) disposed on top of said insulating material strip.

3. The photovoltaic (PV) module (10) as in any preceding claim, wherein said bus tapes (28) include an adhesive layer for attaching to said substrate (12) and to said insulating material strip (32).

4. The photovoltaic (PV) module (10) as in any preceding claim, wherein said solder (30) comprises a low temperature solder having a melting point of between about 100 degrees Celsius to about 150 degrees Celsius.

5. The photovoltaic (PV) module (10) as in claim 4, wherein said solder (30) comprises a Sn-Bi alloy having a melting point of about 138 degrees Celsius.

6. The photovoltaic (PV) module (10) as in any preceding claim, wherein said solder (30) has a thickness about the same as said bus tape (28).

7. A method for attaching bus tapes (28) and a foil ribbon (22) to photovoltaic (PV) module substrates (12), said method comprising:
applying a strip of insulation tape (32) along the length of the substrate;
applying bus tapes (28) at opposite longitudinal ends (18) of the substrate, each of the bus tapes crossing over the insulation tape;
dispensing a low temperature solder (30) onto the top surface of said bus tapes at the crossover location with the insulation tape;
applying a foil ribbon (22) so as to overly the insulation tape and extend over the bus tape and solder at the crossover location; and
heating the substrate at least at the crossover locations to reflow the solder such that the foil ribbon bonds to and makes an electrical connection with the bus tapes.

8. The method as in claim 7, wherein said solder (30) has a melting point of between about 100 degrees Celsius to about 150 degrees Celsius.

9. The method as in claim 7 or claim 8, wherein the solder (30) is heated and reflows in a subsequent lamination step wherein a laminate layer is adhered to the substrate (12).

10. The method as in any of claims 7 to 9, wherein the solder (30) is heated and reflows by application of a localized heat source to the crossover locations.

11. The method as in any of claims 7 to 10, wherein the bus tapes (28) are adhered with an adhesive to the substrate (12) and to the insulation tape (32) at the crossover locations.
